# EUROPEAN PATENT SPECIFICATION

(11) **EP 0 289 137 B1**
(45) Date of publication and mention of the grant of the patent: **16.06.1993**
(21) Application number: 88302716.1
(22) Date of filing: 25.03.1988
(51) Int. Cl.: H05K 3/46, H05K 3/22, H05K 1/00

(54) **Manufacturing printed-circuit components**
Herstellung von Komponenten in gedruckter Schaltungstechnik
Fabrication de composants à circuits imprimés

(30) Priority: 27.03.1987 JP 75040/87
(43) Date of publication of application: 02.11.1988
(73) Proprietor: FUJITSU LIMITED, Kawasaki-shi, Kanagawa 211 (JP)
(72) Inventor: Nagashima, Kanji, Kawasaki-shi Kanagawa 211 (JP); Yamada, Yuji, Sagamihara-shi Kanagawa 228 (JP); Kusagaya, Toshihiro, Kawasaki-shi Kanagawa 214 (JP)
(74) Representative: Billington, Lawrence Emlyn

(56) References cited:
- EP-A- 0 178 409
- DE-A- 2 249 878
- US-A- 3 010 863
- US-A- 3 616 014

## Description

The present invention relates to the manufacture of printed-circuit components, and is concerned more particularly with the use of "green" sheet laminations bearing metallization patterns.

Recently, a greater densification of the packaging of an electric circuit is required in many fields, and a shortening of the length of interconnections and a fining of patterns of a circuit substrate are now essential in the computer field etc. Since the density of interconnections of a thick film circuit substrate is limited, because of the use of the screen printing method, a multilayer substrate made from "green" material sheets is under consideration. To manufacture such a multilayer substrate, a plurality of green sheets on which metallization patterns are printed may be assembled as laminations, pressed under heat, and fired.

In one such process, when a plurality of green sheets are heat pressed, the printed patterns are pushed onto the green sheets and caused to spread transversely. As a result, after firing, the metallization pattern lines have a cross section of a thin ellipse, so it is difficult to produce fine-line patterns while maintaining desirably low electrical resistance.

An embodiment of the present invention, whereby such problems can be reduced comprises a process for laminating a green sheet on a metallized green sheet, comprising the steps of: preparing a first green sheet; printing a metallization pattern on the first green sheet; burying said metallization pattern in the first green sheet while freezing said metallization pattern so that a top surface of the first green sheet is made flat and a cross-sectional shape of said metallization pattern is substantially preserved after burying; and superposing a second green sheet on the first green sheet on a side in which said metallization pattern is buried.

In such an embodiment, a metallization pattern formed on a green sheet by printing is pushed into the green sheet, while the metallization pattern is frozen and preferably the green sheet is heated, until the metallization pattern is buried into the green sheet and a top surface of the green sheet containing the metallization pattern is made flat. In this burying, the cross-sectional shape of the metallization pattern is not substantially changed due to the freezing of the pattern. As a result, the pattern is still fine. In this respect, references to the cross-sectional shape of a metallization pattern are more particularly (but not exclusively) concerned with the line width of the pattern. Further, when such green sheets having a metallization pattern buried therein are laminated and pressed, the metallization pattern is not deformed because the green sheets have a flat top surface and the metallization pattern has been buried in the green sheet. Thus, a multilayer stack of green sheets having a fine pattern can be obtained.

In the accompanying drawings:
Figures 1A to 1D and 2 are cross-sectional diagrams showing a green sheet or laminated green sheet during main steps of one example of a process embodying the present invention; and
Fig. 3 shows respective cross-sectional photographic views of a green sheet and a fired sheet prepared by a prior art process and a process embodying the present invention.

Referring to Fig. 1A, a green sheet 1 is prepared, from alumina having an average particle size in the range from 4 to 5 µm, by casting to form a sheet having a thickness of from 0.2 to 1 mm by a "doctor blade" method, cutting the sheet, punching to form through holes, drying the sheet at a room temperature, and filling the through holes with a metal paste such as tungsten paste. Then, a pattern 2 of tungsten is screen-printed onto the green sheet 1. The tungsten pattern 2 has a line width of 100 µm and a thickness of 50 µm (T/W ratio, i.e. thickness/width ratio, of 0.5).

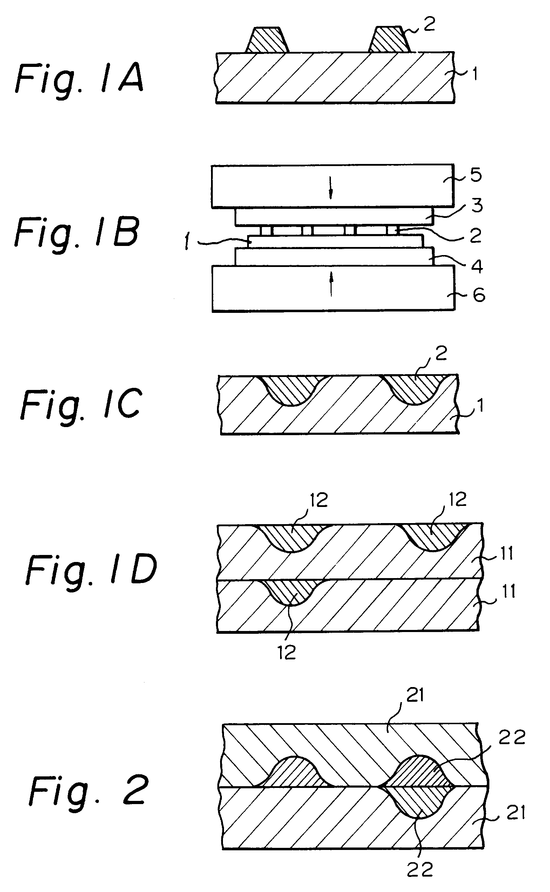

Referring to Fig. 1B, the printed green sheet 1 is placed in a press. The press comprises a hot plate 4 of a steel thermostated to a temperature of 40°C to 90°C and a cold plate 3 of a steel cooled to a temperature of minus 100°C by immersion in liquid nitrogen. The printed green sheet 1 is placed on the hot plate 4, which is set on a lower press plate 6, to soften the green sheet. The cold plate 3 is first immersed in the liquid nitrogen, then taken out and mounted to an upper press plate 5. After the cold plate 3 is mounted on the upper press 5, the upper press 5 is soon driven downward to come into contact with the top surface of the tungsten pattern 2. The tungsten pattern 2 is immediately frozen by this contact with the cold plate 5. The upper press 5 is continuously driven downward to push the pattern 2 into the softened green sheet 1 until the top surface of the pattern 2 becomes level with the top surface of the green sheet 1. In this pressing, a thin top surface layer of the green sheet 1 may be frozen when the cold plate 3 is in contact with the tungsten pattern 2, but the main portion of the green sheet 1 remains unfrozen.

The resulting pressed green sheet 1 is illustrated in Fig. 1C. It can be seen that the tungsten pattern 2 is not substantially damaged during burying from the pattern as printed. The pattern has a thickness of 50 µm and a width of 100 µm, i.e. T/W ratio of 0.5.

Although the cold plate 3 is cooled to -100°C in the above case, the cold plate 3 may have a higher temperature as long as the pattern 2 is frozen thereby. The cold plate 3 may be continuously cooled by a cooling mechanism.

Referring to Fig. 1D, a plurality of green sheets 11 into which tungsten patterns 12 are buried in the manner described above, are stacked and pressed together. In this lamination or pressing process, the tungsten pattern 2 suffers no damage at all and the cross-sectional shape of the pattern is preserved as buried, i.e. substantially as printed.

Figure 2 illustrates another lamination process of green sheets 21, in which respective embedded tungsten patterns 22 are facing and in contact with each other.

In the above example, supersonic vibration can be advantageously applied while the press 5 is pushing the cold plate 3 to press the pattern 2 into the green sheet 1 from a time just after the cold plate 3 comes into contact with the pattern 2. The supersonic vibration and heating of a green sheet can accelerate the burying of a pattern in the green sheet.

The green sheet may be any known green sheet, for example a green sheet of ceramics such as alumina, zirconia, or a glass ceramic. The metallization pattern may be made of any known metallization material, for example a metal paste such as a copper paste, a molybdenum paste, or a silver-palladium alloy paste.

The thus obtained laminate of green sheets may be heat treated by a known method and conditions to sinter the sheets to form a body of a multilayer substrate. The details of such heat treatments are clear to a person skilled in the art and thus need not be mentioned here.

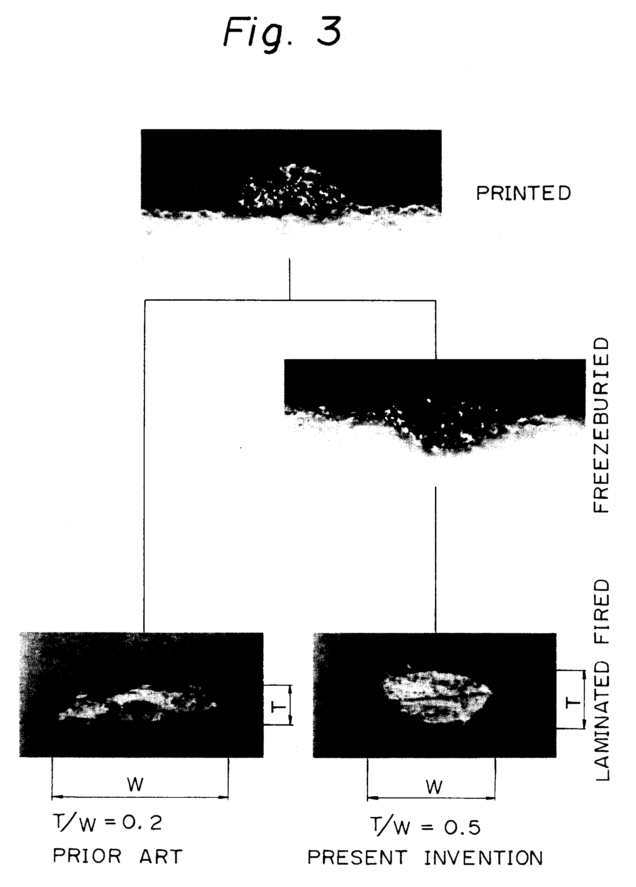

Figure 3 illustrates the advantages of a process embodying the invention. The top photograph is a sectional view of a tungsten pattern printed on a green sheet by screen printing and the printed pattern has a maximum thickness of 50 µm and a width of 100 µm. The middle photograph is a sectional view of the pattern when buried in the green sheet in the course of a process embodying the invention. The right bottom photograph is a sectional view of the pattern after firing, wherein the pattern has a thickness of 40 µm and, a width of 80 µm, i.e., T/W ratio of 0.5. The left bottom photograph is a section view of a pattern after firing prepared from the same pattern as in the top photograph in accordance with a process of the prior art, i.e. by directly laminating and pressing green sheets having pattern printed thereon. This pattern has a thickness of 20 µm and a width of 100 µm, i.e., T/W ratio of 0.2.

The aforementioned heat treatment may include a first heat treatment for removing an organic binder from the green sheets and second heat treatment for sintering them together.

## Claims

1. A method of manufacturing a printed-circuit component, wherein a conductor pattern (2) of metallization material is printed on one surface of a first "green" sheet (1) and then pressed against that surface, characterised in that before being overlaid with any further such sheet the printed conductor pattern is pressed into the first green sheet, whilst being kept frozen to preserve substantially the thickness-to-width ratio of the pattern lines, so as to become embedded into the first green sheet to such an extent that the outer surface of the pattern is substantially level with adjacent portions of the said one surface.

2. A method according to claim 1, wherein said first green sheet is heated while said metallization pattern is frozen and buried in said first green sheet.

3. A method according to claim 2, wherein said first green sheet is heated to a temperature of 40 to 90°C while said metallization pattern is frozen and buried in said first green sheet.

4. A method according to claim 1, 2 or 3, wherein said metallization pattern is frozen by placing a cold plate (3) in contact with said metallization pattern.

5. A method according to claim 4, wherein said cold plate has a temperature of -100°C or lower.

6. A method according to claim 4 or 5, wherein supersonic vibration is applied to said cold plate while said cold plate is pushing said metallization pattern into said first green sheet.

7. A method according to any preceding claim, wherein said first green sheet is a green sheet of a ceramic.

8. A method of manufacturing a multilayer substrate, comprising the steps of:
manufacturing a plurality of printed-circuit components, each by a method as claimed in any one of claims 1 to 7;
stacking the said plurality of components together as a set of laminations; and
heat treating the stacked components so as to fuse them together to form the required multilayer substrate.

9. A method according to claim 8, wherein the heat treating step includes a first heat treatment for removing an organic binder from the green sheets and a second heat treatment for sintering those sheets.

10. A method according to any preceding claim, wherein said printed metallization material is made of a metal paste.

## Patentansprüche

1. Ein Verfahren zum Herstellen einer Komponente einer gedruckten Schaltung, bei dem ein Leitermuster (2) aus Metallisierungsmaterial auf eine Oberfläche eines ersten "rohen" Blattes (1) gedruckt und dann gegen jene Oberfläche gepreßt wird, dadurch gekennzeichnet, daß vor dem Überlagern mit irgendeinem weiteren solchen Blatt das gedruckte Leitermuster in das erste rohe Blatt gepreßt wird, wobei es gefroren bleibt, um das Dicken-Breiten-Verhältnis der Musterlinien im wesentlichen zu beizubehalten, um in das erste rohe Blatt in solch einem Maße eingebettet zu werden, daß die äußere Oberfläche des Musters mit den benachbarten Teilen der genannten einen Oberfläche im wesentlichen ein Niveau hat.

2. Ein Verfahren nach Anspruch 1, bei dem das genannte erste rohe Blatt erwärmt wird, während das genannte Metallisierungsmuster gefroren und in dem genannten ersten rohen Blatt vergraben wird.

3. Ein Verfahren nach Anspruch 2, bei dem das genannte erste rohe Blatt auf eine Temperatur von 40 bis 90°C erwärmt wird, während das genannte Metallisierungsmuster gefroren und in dem genannten ersten rohen Blatt vergraben wird.

4. Ein Verfahren nach Anspruch 1, 2 oder 3, bei dem das genannte Metallisierungsmuster durch Kontaktieren des genannten Metallisierungsmusters mit einer kalten Platte (3) gefroren wird.

5. Ein Verfahren nach Anspruch 4, bei dem die genannte kalte Platte eine Temperatur von -100°C oder niedriger hat.

6. Ein Verfahren nach Anspruch 4 oder 5, bei dem Überschallvibration auf die genannten kalten Platte angewendet wird, während die genannte kalte Platte das genannte Metallisierungsmuster in das genannte erste rohe Blatt drückt.

7. Ein Verfahren nach irgendeinem vorhergehenden Anspruch, bei dem das genannte erste rohe Blatt ein rohes Blatt aus einer Keramik ist.

8. Ein Verfahren zum Herstellen eines Mehrschichtsubstrats mit den Schritten:
Herstellen einer Vielzahl von gedruckten Schaltungskomponenten, jeweils durch ein Verfahren nach irgendeinem der Ansprüche 1 bis 7;
Stapeln der genannten Vielzahl von Komponenten als Schichtungssatz; und
Wärmebehandlung der gestapelten Komponenten, um sie zusammenzuschmelzen, um das geforderte Mehrschichtsubstrat zu bilden.

9. Ein Verfahren nach Anspruch 8, bei dem der Schritt der Wärmebehandlung eine erste Wärmebehandlung zum Entfernen eines organischen Bindemittels aus den rohen Blättern und eine zweite Wärmebehandlung zum Sintern jener Blätter enthält.

10. Ein Verfahren nach irgendeinem vorhergehenden Anspruch, bei dem das genannte gedruckte Metallisierungsmaterial aus einer Metallpaste besteht.

## Revendications

1. Procédé de fabrication d'un composant de circuit imprimé dans lequel un motif conducteur (2) en un matériau de métallisation est imprimé sur une surface d'une première plaque "verte" (1) puis est pressé contre cette surface, caractérisé en ce que, avant d'être recouvert par une quelconque autre plaque, le motif conducteur imprimé est pressé dans la première plaque verte tandis qu'il est maintenu gelé pour préserver sensiblement le rapport épaisseur sur largeur des lignes de motif de manière à devenir enterré dans la première plaque verte jusqu'à un point tel que la surface externe du motif soit sensiblement à niveau avec les parties adjacentes de ladite une surface.

2. Procédé selon la revendication 1, dans lequel ladite première plaque verte est chauffée tandis que ledit motif de métallisation est gelé et enterré dans ladite première plaque verte.

3. Procédé selon la revendication 2, dans lequel ladite première plaque verte est chauffée jusqu'à une température de 40 à 90° C tandis que ledit motif de métallisation est gelé et enterré dans ladite première plaque verte.

4. Procédé selon la revendication 1, 2 ou 3, dans lequel ledit motif de métallisation est gelé en plaçant une plaque froide (3) en contact avec ledit motif de métallisation.

5. Procédé selon la revendication 4, dans lequel ladite plaque froide présente une température de -100° C ou une température inférieure.

6. Procédé selon la revendication 4 ou 5, dans lequel une vibration supersonique est appliquée à ladite plaque froide tandis que ladite plaque froide est en train de pousser ledit motif de métallisation dans ladite première plaque verte.

7. Procédé selon l'une quelconque des revendications précédentes, dans lequel ladite première plaque verte est une plaque verte en céramique.

8. Procédé de fabrication d'un substrat multicouche comprenant les étapes de :
fabrication d'une pluralité de composants de circuit imprimé, chacun au moyen d'un procédé selon l'une quelconque des revendications 1 à 7 ;
empilement de ladite pluralité de composants ensemble en tant que jeu de laminations ; et
traitement thermique des composants empilés de manière à les fondre ensemble pour former le substrat multicouche requis.

9. Procédé selon la revendication 8, dans lequel l'étape de traitement thermique inclut un premier traitement thermique pour ôter un liant organique des plaques vertes et un second traitement thermique pour fritter ces plaques vertes.

10. Procédé selon l'une quelconque des revendications précédentes, dans lequel ledit matériau de métallisation imprimé est constitué par une pâte métallique.
